Europäisches Patentamt

European Patent Office

Office européen des brevets

(11) Veröffentlichungsnummer: **0 325 202**
**A1**

## (12) EUROPÄISCHE PATENTANMELDUNG

(21) Anmeldenummer: 89100724.7

(51) Int. Cl.4: **H01L 21/82 , H01L 21/28**

(22) Anmeldetag: **17.01.89**

(30) Priorität: **20.01.88 DE 3801543**

(43) Veröffentlichungstag der Anmeldung:
**26.07.89 Patentblatt 89/30**

(84) Benannte Vertragsstaaten:
**AT BE DE FR GB IT NL**

(71) Anmelder: **Siemens Aktiengesellschaft Berlin
und München**
**Wittelsbacherplatz 2**
**D-8000 München 2(DE)**

(72) Erfinder: **Hopf, Erwin, Dipl.-Ing.**
**Am Feldl 12**
**D-8011 Egmating(DE)**
Erfinder: **Klingenstein, Werner, Dr.,**
**Dipl.-Phys.**
**Latschenweg 1**
**D-8011 Kirchheim(DE)**

(54) **Verfahren zur Herstellung von VLSI-Logikschaltungen in Poly-Silizium-Gate-NMOS-Technologie mit integriertem EEPROM-Speicher für Tunnelstromprogrammierung.**

(57) Die Erfindung betrifft ein Verfahren zur Herstellung von VLSI-Logikschaltungen in Poly-Silizium-Gate NMOS-Technik zusammen mit integrierten EEPROM-Speichern für Tunnelstromprogrammierung, wobei die notwendige Feldimplantation in zwei Teilschritte aufgeteilt ist und nach der Erzeugung einer NitridOxid-Sandwich-Isolation (7, 8) eine Oxidation in feuchter Atmosphäre bei 850°C ausgeführt wird, bei welcher an den Flanken der Nitridschicht Spacer (10) aufoxidiert werden.

**FIG 2**

EP 0 325 202 A1

## Verfahren zur Herstellung von VLSI-Logikschaltungen in Poly-Silizium-Gate-NMOS-Technologie mit integriertem EEPROM-Speicher für Tunnelstromprogrammierung

Die vorliegende Erfindung betrifft ein Verfahren zur Herstellung von EEPROM-Speicherzellen (Electrically Erasable Programmable Read-Only Memory) für Tunnelstromprogrammierung unter gleichzeitiger Herstellung von VLSI-Logikschaltungen in Poly-Silizium-Gate-NMOS-Technologie auf einem Substrat.

EEPROM-Speicherzellen sind durch ein sogenanntes Floating-Gate, das kapazitiv über eine Isolationsschicht mit einem sogenannten Control-Gate und über ein Gate-Oxid mit einem Drain-Gebiet auf einem Substrat gekoppelt ist, charakterisiert. Das Floating-Gate bildet dabei zusammen mit dem Drain-Gebiet und dem Control-Gate einen kapazitiven Spannungsteiler. Das Gate-Oxid ist in einem kleinen Bereich des Drain-Gebietes dünner ausgeführt. Über diesen, als Tunnelfenster bezeichneten Bereich, fließt bei Anliegen einer ausreichend hohen Feldstärke ein Fowler-Nordheim-Tunnelstrom, der das Floating-Gate auflädt. Sowohl das Control-Gate als auch das Floating-Gate bestehen aus Poly-Silizium-Schichten, die in der Regel mit Phosphor dotiert sind. Die dazwischenliegende Isolationsschicht ist aus Silizium-Oxid oder aber aus einer Nitrid-Oxid-Sandwich-Struktur aufgebaut.

Da durch Anlegen einer Spannung zwischen Drain- bzw. Kanalgebiet und Control-Gate mit Hilfe des kapazitiven Spannungsteilers eine Feldstärke über dem Tunnelfenster erzeugt werden muß, ist die Dicke und die Elektrizitätskonstante der Isolationsschicht zwischen den beiden Poly-Silizium-Schichten von besonderer Bedeutung. Um eine gute Kopplung des Floating-Gates an das Control-Gate zu erreichen, muß die Dielektrizitätskonstante hoch und die Isolationsschicht entsprechend dünn herstellbar sein.

Die europäischen Offenlegungsschriften 0 144 900 und 0 182 198 beschreiben EEPROM-Speicherzellen mit zwei Poly-Silizium-Ebenen und dazwischenliegenden Nitrid-Oxid-Sandwich-Strukturen. Die darin aufgezeigten Herstellungverfahren beschränken sich auf die Herstellung entsprechender Speicherzellen, wobei die erforderlichen Einzelschritte zahlreich und kompliziert sind.

In hochintegrierten Bausteinen ist neben der Integration von EEPROM-Speichern zusätzlich die Integration von Logikschaltungen erforderlich. Hierbei wird zwischen Logikschaltungen mit niedriger Spannung (NV-Logik) und solchen mit hoher Spannung (HV-Logik) unterschieden.

Die bisher bekannten, aus zahlreichen Einzelschritten bestehenden Herstellungsverfahren für Logikschaltungen mit niedriger Spannung und solchen mit hoher Spannung unterscheiden sich so wohl untereinander als auch im Vergleich zu den Herstellungsverfahren für oben beschriebene EEPROM-Speicherzellen erheblich. Eine vorteilhafte Zusammenfügung aller Einzelschritte der vorstehenden Herstellungsverfahren zu einem gemeinsamen Herstellungsprozeß für EEPROM-Speicher und Logikschaltungen ist bisher nicht bekannt.

Aufgabe der vorliegenden Erfindung ist es, einen solchen gemeinsamen Herstellungsprozeß zu schaffen.

Gelöst wird diese Aufgabe dadurch, daß bei einem an sich bekannten gemeinsamen Herstellungsprozeß zur gleichzeitigen Fertigung von EEPROM-Speicherzellen und Logikschaltungen auf einem gemeinsamen Substrat ein Teil der dem Fachmann geläufigen Einzelschritte durch die Prozeßfolge gemäß kennzeichnendem Teil des Patentanspruchs 1 ersetzt werden.

Weitere vorteilhafte Verfahrensschritte sind in den Unteransprüchen beschrieben.

Durch die erfindungsgemäße Aufteilung der Feldimplantation in zwei Prozeßschritte gelingt es, sowohl die Schaltungsteile mit niedriger Spannung als auch die Schaltungsteile mit hoher Spannung sowie die EEPROM-Speicherzellenfelder mit optimalen Parametern herzustellen.

Bei der Erzeugung des Streuoxides in feuchter Atmosphäre bei 850°C entsteht auf den Flanken der Poly-Silizium-1-Schicht selbstjustiert ein 0,1 bis 0,3 $\mu$m breiter Spacer, während die Poly-Silizium-1-Oberfläche, geschützt durch die Silizium-Nitrid-Schicht, nicht oxidiert wird.

Während des Verfließens des Niedertemperatur-Flow-Glases, beispeilsweise Phosphorglas, wird der Phosphor lateral unter den zuvor erzeugten Spacer diffundiert, wodurch ein für die hohe Spannungsfestigkeit notwendiger, weicher pn-Übergang entsteht. Bedingt durch die dadurch erzielte hohe Spannungsfestigkeit kann die Kanallänge kurz ausgelegt werden, ohne daß es beim Betrieb der Speicherzelle zur Generation heißer Ladungsträger kommt. Die Kanallänge des Speichertransistors wird bereits bei der Implantation der $n^+$-dotierten Gebiete eingestellt und hängt nicht von der Länge der Poly-Silizium-1-Struktur ab.

Die als Oxidationsmaske verwendete Silizium-Nitrid-Schicht verbleibt nach der Erzeugung des Spacers auf der Poly-Silizium-1-Schicht und dient im weiteren Verlauf des Herstellungsprozesses als Isolationsschicht zur Poly-Silizium-2-Schicht. Schwachstellen wie Risse oder Pinpols werden während der Spacer-bzw. Streuoxidherstellung selbstjustierend beseitigt. Die Isolationsschicht läßt sich dadurch defektfrei und sehr dünn herstellen.

Die äquivalente Dicke des erzeugten Nitrid-Oxid-Sandwiches ist aufgrund der hohen Dielektrizitätskonstanten von Nitrid um einen Faktor 1,2 bis 1,8 geringer als bei bekannten Oxid-Isolationen gleicher Dicke. Bei vergleichbarer Zuverlässigkeit kann sie deshalb um einen Faktor 2 bis 5 dünner ausgelegt werden. Wenn die kapazitive Kopplung zwischen Control- und Floating-Gate entsprechend hoch ist, können die EEPROM-Zellfläche und die Programmier- bzw. Löschspannungen entsprechend reduziert werden.

Bei konventionellen Oxid-Isolationen wird die minimale Dicke der Isolationsschicht durch Schwachstellen an den Poly-Silizium-1-Kanten begrenzt. Durch die erfindungsgemäß dicke Spacer-Oxid-schicht an den Poly-Silizium-1-Kanten können keine Kurzschlüsse oder elektrische Felddurchbrüche auftreten.

Kontaktlöcher zu den $n^+$-dotierten Gebieten und zur Poly-Silizium-2-Schicht werden dadurch, daß die Streuoxidschicht auf den $n^+$-dotierten Gebieten, und auf den Poly-Silizium-2-Strukturen und die Nitrid-Oxid-Sandwich-Schicht auf den Poly-Silizium-1-Strukturen gleich sind, auch etwa gleich tief. Kontaktlochätz-und Metallisierungsprozesse sind damit leichter beherrschbar.

Der erfindungsgemäße gemeinsame Herstellungsprozeß wird nachstehend anhand von zwei, in der Zeichnung dargestellten Zwischenprodukten erläutert. Es zeigt:

FIG 1 einen Schnitt durch ein Zwischenprodukt bei der Herstellung einer EEPROM-speicherzelle in schematischer und teils gebrochener Darstellung,

FIG 2 in gleicher Darstellung das Zwischenprodukt nach FIG 1, jedoch zu einem späteren Herstellungszeitpunkt.

Bei beiden Figuren sind gleiche Teile mit gleichen Bezugszeichen versehen.

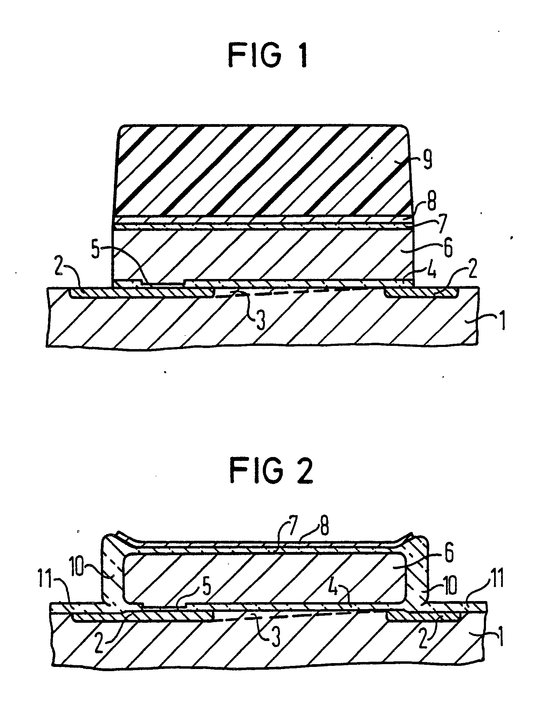

Der in FIG 1 dargestellte Schnitt durch ein bei der Herstellung einer EEPROM-Speicherzelle entstehendes Zwischenprodukt zeigt in einem p-leitenden Substrat 1 zwei $n^+$-dotierte Bereiche 2, die einen Kanalbereich 3 begrenzen. Über dem Kanalbereich 3 und zum Teil auch über den $n^+$-dotierten Bereichen 2 befinden sich der Reihe nach ein Gate-Oxid 4 mit einem Tunnelfenster 5, eine Poly-Silizium-1-Schicht 6, eine dünne Oxidschicht 7 und eine gleichfalls dünne Silizium-Nitrid-Schicht 8. Die Oxidschicht 7 und die Silizium-Nitrid-Schicht 8 bilden zusammen das Nitrid-Oxid-Sandwich. Über diesem befindet sich eine etwa 1 μm dicke Lackmaske 9, welche als Maske für den vorausgegangen anisotropen Ätzschritt diente, bei welchem alle in vorausgehenden Prozeßschritten auf das Substrat 1 aufgetragenen Schichten in der dargestellten Form strukturiert wurden.

Beim Zwischenprodukt nach FIG 2 ist, nachdem beim Zwischenprodukt gemäß FIG 1 für eine EEPROM-Speicherzelle die Lackmaske 9 entfernt wurde, eine Oxidation in feuchter Atmosphäre bei 850° C ausgeführt worden, wobei an den Flanken der Poly-Silizium-1-Schicht 6 selbstjustierte Spacer 10 entstehen, während auf dem Substrat 1 ein Streuoxid 11 erzeugt wird.

## Ansprüche

1. Verfahren zur gleichzeitigen Herstellung von Logikschaltungen und EEPROM-Speicherzellen für Tunnelstromprogrammierung in Poly-Silizium-Gate-NMOS-Technologie auf einem gemeinsamen Substrat (1), **dadurch gekennzeichnet,** daß ein Teil eines an sich bekannten Herstellungsverfahrens durch folgende Prozeßfolge ersetzt wird:
- Herstellen der aktiven Gebiete für die Logikschaltungen niedriger und hoher Spannungen sowie der EEPROM-Speicherzellen durch Feldimplantation,
- Erzeugung eines Gate-Oxids (4) mit der Dicke $d_1$,
- Abätzen dieses Gate-Oxids (4) in den Gebieten der Logikschaltungen niedriger Spannung,
- Erzeugung eines weiteren Oxids, das innerhalb der Gebiete der Logikschaltungen für niedrige Spannung zur Dicke $d_2$ und in den Gebieten der Logikschaltungen für hohe Spannung sowie im Gebiet der EEPROM-Speicherzellen auf die Dicke $d_3$ aufoxidiert,
- Herstellen von Kanalbereichen im Gebiet der Logikschaltungen und von Burried-Channel-Bereichen im Gebiet der EEPROM-Speicherzellen durch Implantation,
- Ausheilen der Kristallschäden in den $n^+$-dotierten Gebieten (2) und Einstellen der Dotierstoffprofile durch eine Hochtemperaturbelastung in Inertgasatmosphäre,
- Ätzen eines Tunnelfensters (5) mit anschließender Oxidation bis zur Enddicke des Gate-Oxids,
- Herstellen einer phosphordotierten Poly-Silizium-1-Schicht,
- Herstellen einer dünnen Oxidschicht auf der Poly-Silizium-1-Schicht mit anschließender Abscheidung einer dünnen Silizium-Nitrid-Schicht,
- anisotropes Ätzen aller bisher aufgetragener Schichten bis zum Substrat (1) mit Hilfe einer Lackmaske (9),
- Oxidation von Spacern (10) und Streuoxid (11) in einem gemeinsamen Schritt in feuchter Atmosphäre bei 850° C,
- Abscheiden einer Poly-Silizium-2-Schicht und Strukturieren derselben mit Hilfe einer Lackmaske,
- Implantation von Phosphor zur Erzeugung der Source- und Drain-Bereiche und

- kurze Reoxidation, Abscheiden und Verfließen eines Niedertemperatur-Flowglases bei 850 bis 900 °C.

2. Verfahren nach Anspruch 1, **dadurch gekennzeichnet,** daß bei der Feldimplantation in einem ersten Schritt alle nichtaktiven Gebiete entsprechend den Anforderungen der Logikschaltungen für niedrige Spannung implantiert, danach diese Gebiete mit einer Implantationsmaske abgedeckt und in einem weiteren Schritt die Gebiete mit höherer Spannung ein zweites Mal implantiert werden.

3. Verfahren nach Anspruch 1 oder 2, **dadurch gekennzeichnet,** daß die Poly-Silizium-2-Schicht während der Source-Drain-Implantation mit Phosphor dotiert wird.

4. Verfahren nach einem der vorhergehenden Ansprüche, **dadurch gekennzeichnet,** daß mindestens eine der beiden Poly-Silizium-Schichten bereits dotiert abgeschieden wird.

5. Verfahren nach einem der vorhergehenden Ansprüche, **dadurch gekennzeichnet,** daß die Kanalbereiche (3) und die Burried-Channel-Bereiche erst nach der Herstellung des Gate-Oxides implantiert werden.

6. Verfahren nach einem der vorhergehenden Ansprüche, **dadurch gekennzeichnet,** daß vor der Implantation mit Phosphor eine Voramorphisierung durch Silizium-Implantation erfolgt.

# FIG 1

# FIG 2

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| A | EP-A-0 197 284 (FUJITSU LTD) <br> * Ansprüche 1-15 * <br> --- | 1 | H 01 L 21/82 <br> H 01 L 21/28 |
| A | EP-A-0 210 809 (XICOR INC.) <br> * Ansprüche 16-18 * <br> ----- | 1 | |

**RECHERCHIERTE SACHGEBIETE (Int. Cl.4)**

H 01 L

Der vorliegende Recherchenbericht wurde für alle Patentansprüche erstellt

| Recherchenort | Abschlußdatum der Recherche | Prüfer |
|---|---|---|
| DEN HAAG | 18-04-1989 | ZOLLFRANK G.O. |